(19) Europäisches Patentamt
European Patent Office
Office européen des brevets

(11) **EP 2 770 162 B1**

(12) **FASCICULE DE BREVET EUROPEEN**

(45) Date de publication et mention
de la délivrance du brevet:
**25.05.2016 Bulletin 2016/21**

(51) Int Cl.:
***G01V 99/00*** *(2009.01)*    ***E21B 43/16*** *(2006.01)*
***G01V 9/00*** *(2006.01)*

(21) Numéro de dépôt: **14305202.5**

(22) Date de dépôt: **14.02.2014**

(54) **Procédé d'exploitation d'un réservoir géologique au moyen d'un modèle de réservoir calé et cohérent vis à vis des propriétés d'écoulement**

Verfahren zur Ausbeutung eines geologischen Speichers mit Hilfe eines intelligenten und kohärenten Speichermodells in Bezug auf die Ablaufeigenschaften

Method for exploiting a geological reservoir by means of a wedge model of the reservoir that is consistent with the flow properties

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.02.2013 FR 1351509**

(43) Date de publication de la demande:
**27.08.2014 Bulletin 2014/35**

(73) Titulaire: **IFP Énergies nouvelles
92852 Rueil-Malmaison Cedex (FR)**

(72) Inventeurs:
• **Le Ravalec, Mickaele
  92500 RUEIL-MALMAISON (FR)**
• **Preux, Christophe
  78260 ACHERES (FR)**
• **Enchery, Guillaume
  92500 RUEIL-MALMAISON (FR)**
• **Lange, Arnaud
  92500 Rueil-Malmaison (FR)**

(56) Documents cités:
**EP-A1- 2 253 797    US-A1- 2013 020 131**

**Description**

La présente invention concerne le domaine technique de l'industrie pétrolière, et plus particulièrement l'exploitation de réservoirs souterrains, tels que des réservoirs pétroliers ou des sites de stockage de gaz.

En particulier, l'invention permet de modifier des représentations du réservoir, appelées modèles de réservoir, pour les rendre cohérentes avec les différentes données collectées sur le terrain.

L'optimisation et l'exploitation d'un gisement pétrolier reposent sur une description aussi précise que possible de la structure, des propriétés pétrophysiques, des propriétés des fluides, etc., du gisement étudié. Pour ce faire, les spécialistes utilisent un outil qui permet de rendre compte de ces aspects de façon approchée : le modèle de réservoir. Un tel modèle constitue une maquette du sous-sol, représentative à la fois de sa structure et de son comportement. Généralement, ce type de maquette est représenté sur un ordinateur, et l'on parle alors de modèle numérique. Un modèle de réservoir comporte un maillage ou grille, généralement tridimensionnel, associé à une ou plusieurs cartes de propriétés pétrophysiques (faciès, porosité, perméabilité, saturation...). L'association consiste à attribuer des valeurs de ces propriétés pétrophysiques à chacune des mailles de la grille.

Ces modèles bien connus et largement utilisés dans l'industrie pétrolière, permettent de déterminer de nombreux paramètres techniques relatifs à l'étude ou l'exploitation d'un réservoir, d'hydrocarbures par exemple. En effet, puisque le modèle de réservoir est représentatif de la structure du réservoir et de son comportement, l'ingénieur l'utilise par exemple pour déterminer les zones qui ont le plus de chances de contenir des hydrocarbures, les zones dans lesquelles il peut être intéressant/nécessaire de forer un puits d'injection ou de production pour améliorer la récupération des hydrocarbures, le type d'outils à utiliser, les propriétés des fluides utilisés et récupérés.... Ces interprétations de modèles de réservoir en termes de « paramètres techniques d'exploitation » sont bien connues des spécialistes. De la même façon, la modélisation des sites de stockages de $CO_2$ permet de surveiller ces sites, de détecter des comportements inattendus et de prédire le déplacement du $CO_2$ injecté.

Un modèle de réservoir a donc pour vocation de rendre compte, au mieux, de toutes les informations connues sur un réservoir. Un modèle de réservoir est représentatif lorsqu'une simulation de réservoir fournit des réponses numériques très proches des données d'historique déjà observées. On appelle données d'historique, les données de production issues de mesures aux puits en réponse à la production du réservoir (production d'huile, production d'eau d'un ou plusieurs puits, temps de percée, ratio gaz/huile (GOR), proportion d'eau de production ("water cut"), et/ou les données de sismiques répétitives (impédances sismiques 4D dans une ou plusieurs régions, etc.).

Une simulation de réservoir est une technique permettant de simuler les écoulements de fluides au sein d'un réservoir au moyen d'un logiciel appelé simulateur d'écoulement, et du modèle de réservoir. Par exemple, les logiciels PumaFlow ® (IFP Energies nouvelles, France) et ECLIPSE ® (Schlumberger, États-Unis) sont des simulateurs d'écoulement.

Pour ce faire, l'intégration de toutes les données disponibles est indispensable. Ces données comprennent en général :

- des mesures en certains points de la formation géologique de la propriété modélisée, par exemple dans des puits. Ces données sont dites statiques car elles sont invariables dans le temps (à l'échelle des temps de la production du réservoir) et sont directement liées à la propriété d'intérêt.

- des "données d'historique", comprenant des données de production, par exemple les débits de fluide mesurés aux puits, les concentrations de traceurs et des données issues de campagnes d'acquisition sismique répétées à des temps successifs. Ces données sont dites dynamiques car elles évoluent en cours d'exploitation et sont indirectement liées aux propriétés attribuées aux mailles du modèle de réservoir.

Les données statiques disponibles sont utilisées pour définir des fonctions aléatoires pour chaque propriété pétrophysique comme la porosité ou la perméabilité. Une représentation de la répartition spatiale d'une propriété pétrophysique est une réalisation d'une fonction aléatoire. De façon générale, une réalisation est générée à partir d'un germe ou d'une série de nombres aléatoires. De nombreuses techniques de simulation existent comme la méthode de simulation séquentielle par Gaussiennes, la méthode de Cholesky ou encore la méthode FFT-MA (transformée de Fourier rapide avec moyenne mobile). Les documents suivants décrivent de telles méthodes :

- EP2253797
- Goovaerts,P., 1997, Geostatistics for natural resources evaluation, Oxford Press, New York.
- Le Ravalec, M., Noetinger B., and Hu L.-Y., 2000, The FFT moving average (FFT-MA) generator: an efficient numerical method for generating and conditioning Gaussian simulations, Mathematical Geology, 32(6), 701-723.

Les techniques d'intégration des données dynamiques (production et/ou sismique 4D) dans un modèle de réservoir sont bien connues des spécialistes : ce sont des techniques dites de "calage d'historique" ("history-matching" en anglais). Le calage d'historique consiste à modifier les paramètres d'un modèle de réservoir, tels que les perméabilités, les porosités ou les skins de puits (représentant les endommagements autour du puits), les connections de failles..., pour minimiser les écarts entre les données d'historique mesurées et les réponses correspondantes simulées à partir du modèle au moyen d'un simulateur d'écoulement. Les paramètres peuvent être liés à des régions géographiques comme les perméabilités ou porosités autour d'un ou plusieurs puits. L'écart entre données réelles et réponses simulées forme une fonctionnelle, dite fonction objectif. Le problème du calage d'historique se résout en minimisant cette fonctionnelle. Des techniques de perturbation du modèle de réservoir permettent de modifier une réalisation d'une fonction aléatoire tout en assurant le fait que la réalisation perturbée est aussi une réalisation de cette même fonction aléatoire. Parmi ces techniques de perturbation, on peut citer la méthode des points pilotes développée par RamaRao et al. (1995) et Gomez-Hernandez et al. (1997), la méthode des déformations graduelles proposée par Hu (2000) et la méthode de perturbation des probabilités introduite par Caers (2003). Ces méthodes permettent de modifier la distribution spatiale des hétérogénéités :

- RamaRao, B.S, Lavenue, A.M., Marsilly, G. de, Marietta, M.G., 1995, Pilot point methodology for automated calibration of an ensemble of conditionally simulated transmissivity fields. 1. Theory and computational experiments. WRR, 31 (3), 475-493.

- Gomez-Hernandez, J., Sahuquillo, A., et Capilla, J.E., 1997, Stochastic simulation of transmissivity fields conditional to both transmissivity and piezometric data, 1. Theory, J. of Hydrology, 203, 162-174.

- Hu, L-Y., 2000, Gradual Deformation and iterative calibration of Gaussian-related stochastic models, Math. Geol., 32(1), 87-108.

- Caers, J., 2003, Geostatistical history matching under training-image based geological constraints. SPE J. 8(3), 218-226.

La détermination d'un modèle de réservoir calé respectant les données de production est fortement pénalisée par les temps de calcul requis. En effet, le processus de calage implique un nombre très important d'itérations. Pour chacune d'entre elles, le modèle est donné en entrée à un simulateur d'écoulement et les réponses calculées sont comparées aux données de production disponibles. Or, le temps de calcul pour une simulation est en général de l'ordre de quelques heures. Par conséquent, les spécialistes cherchent à limiter le nombre d'itérations du calage d'historique pour limiter le temps et le coût de calcul (simulations) tout en obtenant un modèle de réservoir représentatif du réservoir géologique.

L'invention concerne un procédé d'exploitation d'un réservoir géologique selon un schéma d'exploitation défini à partir d'un modèle de réservoir calé avec des données statiques et des données dynamiques. Afin de diminuer le nombre d'itérations du processus de calage d'historique, on pré-sélectionne un premier modèle de réservoir affichant une certaine cohérence vis à vis des propriétés d'écoulement du milieu. Ce modèle pré-sélectionné est alors utilisé comme point de départ pour le processus de calage et permet d'aboutir à un modèle respectant l'ensemble des données de production en un nombre réduit d'itérations.

**Le procédé selon l'invention**

L'invention concerne un procédé d'exploitation d'un réservoir géologique selon un schéma d'exploitation défini à partir d'un modèle de réservoir, ledit modèle de réservoir comportant un maillage associé à au moins un paramètre dudit réservoir, ledit réservoir étant traversé par au moins un puits producteur et au moins un puits injecteur pour l'injection d'au moins un fluide dans ledit réservoir, procédé pour lequel on acquiert des données dynamiques en cours d'exploitation. Pour ce procédé, on réalise les étapes suivantes :

a) on génère un premier modèle de réservoir pour lequel le temps de percée estimé au moyen dudit premier modèle de réservoir est représentatif du temps de percée mesuré pour ledit réservoir, ledit temps de percée étant le temps au bout duquel ledit fluide injecté est détecté au niveau dudit puits producteur ;
b) on construit ledit modèle de réservoir en modifiant ledit premier modèle de réservoir au moyen des étapes suivantes :

i) on détermine une fonction objectif mesurant un écart entre les données dynamiques acquises et des données dynamiques simulées au moyen dudit modèle de réservoir et d'un simulateur d'écoulement ;
ii) on réitère l'étape i) pour minimiser ladite fonction objectif après avoir modifié ledit modèle de réservoir ;

c) on détermine un schéma d'exploitation optimal dudit réservoir en simulant l'exploitation du réservoir au moyen dudit modèle de réservoir et dudit simulateur d'écoulement ; et

d) on exploite ledit réservoir en mettant en oeuvre ledit schéma d'exploitation optimal.

Selon l'invention, ledit temps de percée est déterminé par un algorithme de calcul de chemin le plus court.

Avantageusement, on génère ledit premier modèle de réservoir, en mettant en oeuvre les étapes suivantes :

(1) on détermine une relation mathématique entre ledit temps de percée et une distance d'écoulement selon le plus court chemin entre ledit puits injecteur et ledit puits producteur ;

(2) on génère aléatoirement au moins un modèle de réservoir initial ;

(3) on détermine pour ledit modèle de réservoir initial ladite distance d'écoulement selon le plus court chemin entre ledit puits injecteur et ledit puits producteur au moyen d'un algorithme de calcul de chemin le plus court, ledit algorithme étant contraint par ledit paramètre dudit modèle de réservoir initial ;

(4) on estime le temps de percée pour ledit modèle de réservoir initial au moyen de ladite distance d'écoulement et de ladite relation mathématique ;

(5) on compare ledit temps de percée estimé audit temps de percée mesuré ; et

(6) on détermine si ledit modèle de réservoir initial est représentatif au moyen de ladite comparaison, dans ce cas le modèle de réservoir initial est sélectionné en tant que premier modèle de réservoir et dans le cas contraire on réitère les étapes (2) à (5).

De manière avantageuse, on détermine ladite relation mathématique entre ledit temps de percée et ladite distance d'écoulement, en effectuant les étapes suivantes :

(a) on génère aléatoirement au moins un modèle de réservoir primaire ;

(b) on détermine pour chaque modèle de réservoir primaire au moins une distance d'écoulement selon le chemin le plus court au moyen dudit algorithme de calcul de chemin le plus court ;

(c) on détermine pour chaque modèle de réservoir primaire ledit temps de percée par une simulation au moyen dudit modèle de réservoir primaire et dudit simulateur d'écoulement ; et

(d) on détermine ladite relation mathématique entre ledit temps de percée et ladite distance d'écoulement au moyen de chaque distance d'écoulement et de chaque temps de percée déterminés.

De préférence, ladite relation mathématique est une fonction linéaire.

Selon un mode de réalisation de l'invention, ledit algorithme de calcul de chemin le plus court est l'algorithme de Dijkstra.

Avantageusement, la longueur d'un lien entre deux mailles adjacentes i et j utilisée par ledit algorithme de chemin le plus court est définie par une formule du type :

$$Longueur_{i \to j} = \frac{\sqrt{Vp_i \times Vp_j}}{T_{i \leftrightarrow j}(P_i - P_j)} \text{ avec } T_{i \leftrightarrow j} = \frac{A_{ij}K_{ij}}{D_{ij}}$$

avec : $T_{i \leftrightarrow j}$ : la transmissivité entre les mailles i et j,

$A_{ij}$ : la surface d'intersection entre les mailles i et j,

$D_{ij}$ : la distance entre les mailles i et j,

$K_{ij}$ : la perméabilité moyenne le long de la connexion entre les mailles i et j,

$Vp_i$ : le volume poreux de la maille i,

$Vp_j$ : le volume poreux de la maille j,

$P_i$ : la pression de fluide dans la maille i, et

$P_j$ : la pression de fluide dans la maille j.

En outre, préalablement à la détermination de ladite fonction objectif, on peut réaliser une mise à l'échelle dudit modèle de réservoir pour ladite simulation.

Selon l'invention, ladite fonction objectif mesure l'erreur entre le débit dudit fluide mesuré audit puits producteur et le débit dudit fluide simulé audit puits producteur.

Avantageusement, on modifie ledit modèle de réservoir au moyen d'une méthode des déformations graduelles, d'une méthode des points pilotes ou d'une méthode de perturbation des probabilités.

En outre l'invention concerne un produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé tel que décrit ci-dessus, lorsque ledit programme est exécuté sur un ordinateur.

**Présentation succincte des figures**

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre un ordinogramme du procédé selon l'invention.

La figure 2 illustre un ordinogramme du procédé selon un mode de réalisation de l'invention.

Les figures 3a) et 3b) illustrent des chemins le plus court pour un exemple selon deux méthodes de calcul de chemin le plus court. La figure 3c) représente la saturation en eau au temps de percée simulée pour l'exemple des figures 3a) et 3b).

La figure 4 illustre une corrélation entre le temps de percée et la distance du chemin le plus court.

La figure 5 représente un champ de perméabilité pour un exemple.

La figure 6 illustre les débits d'eau simulés au niveau des quatre puits productions pour l'exemple de la figure 5.

Les figures 7a) à 7d) illustrent les corrélations entre le temps de percée et la distance du chemin le plus court pour les quatre puits de l'exemple de la figure 5.

La figure 8 est une courbe de la fonction objectif en fonction du nombre de simulations pour le procédé selon l'art antérieur et pour le procédé selon l'invention pour l'exemple de la figure 5.

**Description détaillée de l'invention**

L'invention concerne un procédé d'exploitation d'un réservoir géologique, notamment d'un réservoir contenant des hydrocarbures. Le réservoir géologique est traversé par au moins un puits producteur et au moins un puits injecteur, pour l'injection d'au moins un fluide (par exemple de l'eau) dans le réservoir. Par "hydrocarbures", on entend au sens de la présente invention des produits pétrolifères tels que du pétrole ou de l'huile brute, du pétrole ou de l'huile extra-lourde, des sables asphalténiques, des schistes bitumineux et des gaz présents dans une formation souterraine. Le procédé selon l'invention est également adapté à l'exploitation des réservoirs de stockage de gaz, tels que le $CO_2$. Pour le réservoir étudié, on connaît des données statiques (par exemple la perméabilité et la porosité) ainsi que des données dynamiques (par exemple des données de production et de sismiques), mais aussi les temps de percée. Les temps de percée correspondent aux temps auxquels sont détectées au niveau des puits producteurs les premières traces du fluide injecté (eau, traceurs...).

Au moyen du procédé selon l'invention, on définit un schéma d'exploitation du réservoir au moyen d'une simulation d'écoulement pour un modèle de réservoir représentatif des propriétés pétrophysiques et géologiques du réservoir. Le modèle de réservoir utilisé est déterminé par un processus de calage d'historique à partir d'un premier modèle de réservoir pertinent pré-sélectionné. Pour pré-sélectionner des modèles de réservoir pertinents, on se concentre sur les temps de percée.

Pour cette demande, les termes : "premier modèle de réservoir", "modèle de réservoir initial" et "modèle de réservoir primaire" désignent tous des modèles de réservoir tels que définis dans la partie introductive de cette demande. L'adjectif utilisé (premier, initial, primaire) n'indique pas de différence dans la construction de ces modèles mais permet de les différencier en fonction de leur rôle. En effet, le premier modèle de réservoir est utilisé dans le processus de calage, le modèle de réservoir initial est utilisé dans le choix du premier modèle de réservoir et le modèle de réservoir primaire est utilisé pour déterminer la relation entre le temps de percée et la distance d'écoulement selon le chemin le plus court.

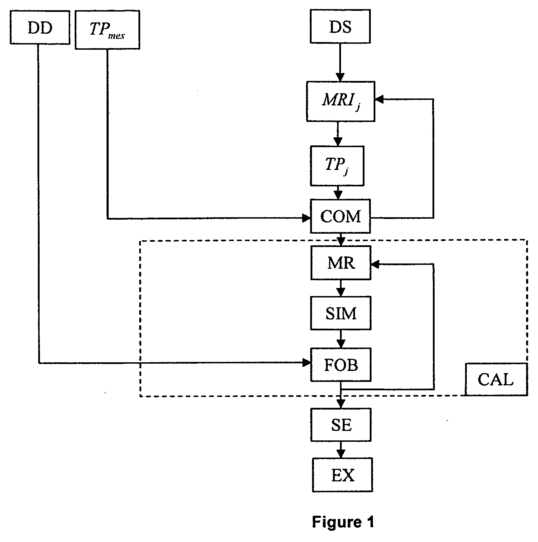

La figure 1 représente un premier mode de réalisation du procédé selon l'invention, pour lequel on réalise les étapes suivantes :

1) construction d'un premier modèle de réservoir (MR)
2) minimisation de la fonction objectif (FOB)

3) détermination du schéma d'exploitation (SE)

4) exploitation du réservoir (EX)

Selon le mode de réalisation de la figure 1, décrit plus en détail par la suite, l'étape de génération d'un premier modèle de réservoir (MR) est réalisé par le choix d'un modèle de réservoir initial ($MRI_j$) pour lequel le temps de percée estimé ($TP_j$) est proche du temps de percée estimé ($TP_{mes}$), l'estimation pouvant être réalisée au moyen d'une relation mathématique (REL).

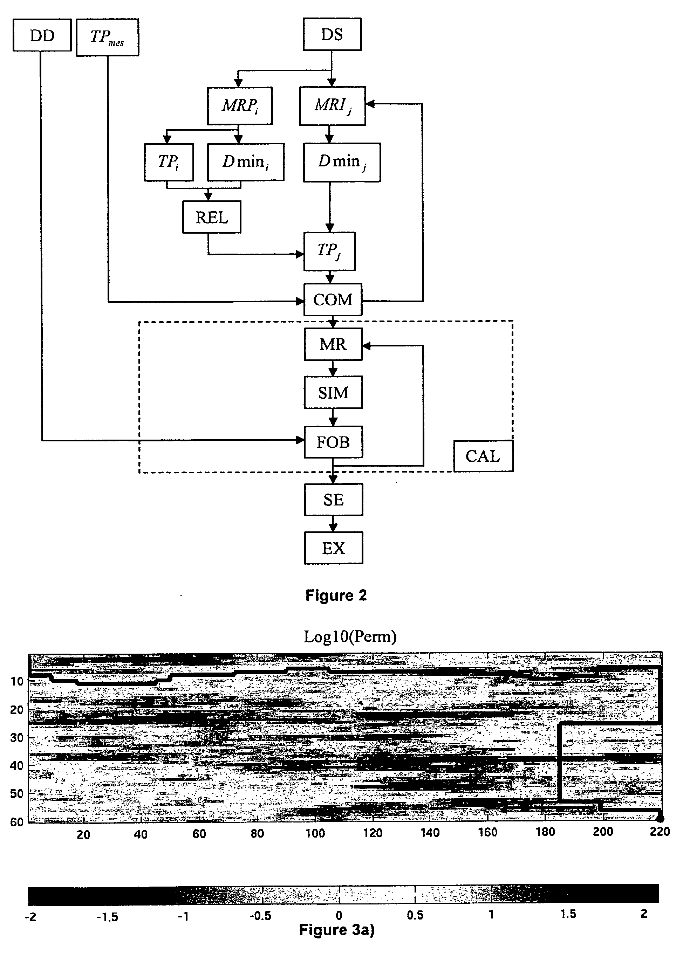

Selon un deuxième mode de réalisation, tel qu'illustré en figure 2 et décrit plus en détail par la suite, l'estimation est réalisée au moyen d'une relation mathématique (REL) déterminée au moyen de distances d'écoulement ($D\,min_i$) et de temps de percée simulés ($TP_i$) déterminés à partir de modèles de réservoir primaires ($MRP_i$).

<u>1) construction d'un premier modèle de réservoir (MR)</u>

Selon le procédé selon l'invention, on pré-sélectionne un premier modèle de réservoir de manière que le temps de percée estimé pour ce premier modèle de réservoir soit cohérent avec le temps de percée mesuré. Les modèles de réservoir sont déterminés aléatoirement en fonction des données statiques, notamment au moyen de simulations géostatistiques. L'analyse des données statiques (DS) disponibles (géologiques, pétrophysiques et géophysiques) permet de définir une loi de probabilité a priori. La génération de modèle de réservoir consiste donc à faire des tirages aléatoires suivant cette loi de probabilité et ainsi à générer au hasard des modèles de réservoir au moyen d'un logiciel adapté.

Selon une première variante de réalisation du procédé selon l'invention (cf. figure 1), on peut simuler les écoulements dans le réservoir au moyen d'un simulateur d'écoulement et de plusieurs modèles de réservoir et on sélectionne en tant que premier modèle de réservoir le modèle de réservoir pour lequel le temps de percée est le plus proche du temps de percée mesuré.

Selon une deuxième variante de réalisation du procédé selon l'invention tel qu'illustré en figure 2, on met en oeuvre les étapes suivantes :

(1) on détermine une relation mathématique (REL) entre ledit temps de percée et une distance d'écoulement selon le plus court chemin entre ledit puits injecteur et ledit puits producteur, la relation mathématique (REL) étant avantageusement une fonction reliant le temps de percée et la distance d'écoulement selon le plus court chemin, cette fonction pouvant être du type linéaire, polynomiale... ;

(2) on génère aléatoirement au moins un modèle de réservoir initial ($MRI_j$) en fonction des données statiques (DS) ;

(3) on détermine pour le modèle de réservoir initial la distance d'écoulement ($D\,min_j$) selon le plus court chemin au moyen d'un algorithme de calcul de chemin le plus court, l'algorithme étant contraint par le paramètre du modèle de réservoir initial ;

(4) on estime le temps de percée ($TP_j$) pour le modèle de réservoir initial en appliquant la relation mathématique (REL) à la distance d'écoulement déterminée ;

(5) on compare (COM), notamment par différence, le temps de percée estimé *($TP_j$)* au temps de percée mesuré ($TP_{mes}$) ; et

(6) on détermine si le modèle de réservoir initial est représentatif du réservoir géologique au moyen de la comparaison (COM), dans ce cas le modèle de réservoir initial est pré-sélectionné en tant que premier modèle de réservoir, dans le cas contraire on réitère les étapes (2) à (5) en générant un nouveau modèle de réservoir initial ($MRI_j$). Avantageusement, on considère que le modèle de réservoir initial est représentatif si l'écart entre le temps de percée estimé et le temps de percée mesuré est faible, c'est-à-dire inférieure à 15%, de préférence inférieure à 10 % du temps de percée mesuré. Selon une deuxième variante de réalisation, on calcule le temps de percée pour un nombre prédéterminé de modèles de réservoir et on sélectionne celui qui minimise la différence. D'autres critères peuvent être envisagés.

Ce mode de réalisation permet de limiter l'utilisation du simulateur d'écoulement, donc de limiter le temps de calcul.

Avantageusement, selon une possibilité de mise en oeuvre de la deuxième variante de réalisation telle qu'illustrée en figure 2, la relation mathématique (REL) peut être déterminée en mettant en oeuvre les étapes suivantes :

(a) on génère aléatoirement au moins un (de préférence un nombre prédéterminé) modèle de réservoir primaire ($MRP_i$) en fonction des données statiques (DS) ;

(b) on détermine pour chaque modèle de réservoir primaire au moins une distance d'écoulement ($D\,min_i$) selon le chemin le plus court au moyen de l'algorithme de calcul de chemin le plus court ;

(c) on détermine pour chaque modèle de réservoir primaire le temps de percée ($TP_i$) par une simulation au moyen du modèle de réservoir primaire et d'un simulateur d'écoulement ; et

(d) on détermine la relation mathématique (REL) entre le temps de percée (*TP$_i$*) et la distance d'écoulement (*D* min$_i$) au moyen de chaque distance d'écoulement et de chaque temps de percée déterminés.

Les étapes (a) et (b) peuvent être réalisées dans cet ordre, dans l'ordre inverse ou simultanément. Le nombre prédéterminé de modèles de réservoir primaires est de préférence réduit, afin de réduire le temps de simulation, donc le temps de calcul du procédé.

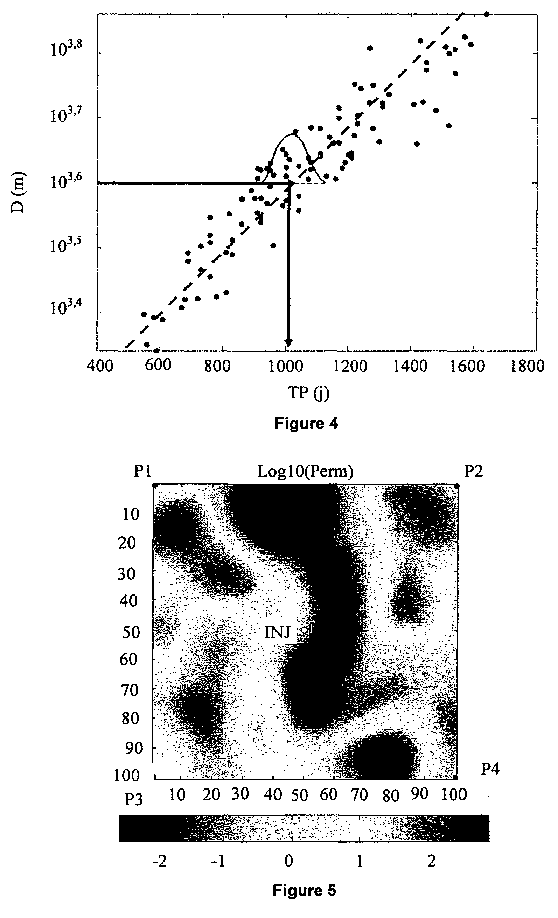

De préférence, la relation mathématique est une relation linéaire, la figure 4 représente le lien entre le temps de percée TP en jours et la distance D d'écoulement en mètre selon le chemin le plus court. Sur cette courbe, on peut observer une linéarité entre ces deux paramètres.

Selon l'invention, l'identification du chemin le plus court est réalisée sans l'utilisation d'un simulateur d'écoulement. Il s'agit d'utiliser une méthode efficace en temps de calcul pour identifier les chemins d'écoulement les plus courts entre les différents puits. On s'appuie donc sur un algorithme de parcours de graphe et de résolution du problème du plus court chemin, cet algorithme est également appelé algorithme de calcul de chemin le plus court.

Les problèmes de calcul du chemin le plus court, appelés également problèmes de cheminement sont des problèmes classiques de la théorie des graphes. L'objectif est de calculer une route entre des sommets d'un graphe qui minimise ou maximise une certaine fonction économique. Il existe des algorithmes polynomiaux pour résoudre ce problème, tel que l'algorithme de Dijkstra.

Avantageusement, pour chaque puits injecteur, on calcule tous les chemins entre celui-ci et ses puits producteurs, c'est à dire les puits producteurs qui sont affectés par l'injecteur (le choix des producteurs "liés" à l'injecteur se fait généralement en regardant le schéma d'exploitation : dans le cas d'un "five spot", on calcule les chemins entre le puits injecteur et ses puits producteurs mais on ne calcule pas la distance entre ce puits injecteur et un puits producteur qui fait parti d'un autre "five spot" plus loin sur le champs : ce n'est pas utile).

Ce chemin le plus court est dépendant des propriétés pétrophysiques et géologiques du réservoir, notamment de la perméabilité, contenues dans les mailles des modèles.

Selon un mode de réalisation de l'invention, on utilise l'algorithme de Dijkstra pour déterminer la distance d'écoulement entre le puits injecteur et le puits producteur selon le plus court chemin. D'autres algorithmes, tels que l'algorithme de Ford-Bellman ou l'algorithme de Gabow peuvent être utilisés pour le procédé selon l'invention. Cette liste n'est pas exhaustive.

Dans notre cas, les mailles de la grille réservoir sont assimilées à des noeuds connectés entre eux par des liens. Un point important est l'évaluation de la longueur des liens. Selon l'invention, on peut estimer ces longueurs comme le rapport du volume poreux sur la transmissivité. On rappelle que de façon générale la transmissivité $T_{ij}$ du lien connectant 2 mailles adjacentes *i* et *j* vaut :

$$T_{i \leftrightarrow j} = \frac{A_{ij} K_{ij}}{D_{ij}}$$

avec : $T_{i \leftrightarrow j}$ : la transmissivité entre les mailles i et j, $A_{ij}$ : la surface d'intersection entre les mailles i et j, $K_{ij}$ : la perméabilité moyenne le long de la connexion entre les mailles i et j, et D$_{ij}$ : la distance entre les mailles i et j. Ces différents paramètres sont à expliciter en fonction du schéma de discrétisation choisi. Dans tous les cas, cette définition de la transmissivité implique que la longueur d'un lien est fonction de propriétés statiques uniquement et on montre que le chemin le plus court entre deux puits identifiés à partir de cette métrique est différent du chemin d'écoulement le plus court (la figure 3a) représente un chemin d'écoulement le plus court pour une prise en compte d'une longueur classique en fonction du logarithme de la perméabilité Log10(Perm)).

Selon l'invention, on peut modifier la définition de la longueur d'un lien en y intégrant une information relative à l'écoulement des fluides. L'idéal est de calculer précisément le champ de pression à l'aide d'un simulateur d'écoulement. Pour réduire les temps de calcul, on approche les pressions en résolvant l'équation de Darcy (par exemple au moyen d'une simulation d'écoulement avec un seul pas de temps). La longueur d'un lien entre 2 mailles adjacentes *i* et *j* devient :

$$Longueur_{i \rightarrow j} = \frac{\sqrt{Vp_i \times Vp_j}}{T_{i \leftrightarrow j}(P_i - P_j)}$$

avec $Vp_i$ : le volume poreux de la maille i, $Vp_j$ : le volume poreux de la maille j, $P_i$ : la pression du fluide présent dans le milieu poreux (il peut s'agit du fluide injecté et/ou des hydrocarbures) de la maille i, et $P_j$ : la pression du fluide présent dans le milieu poreux de la maille j.

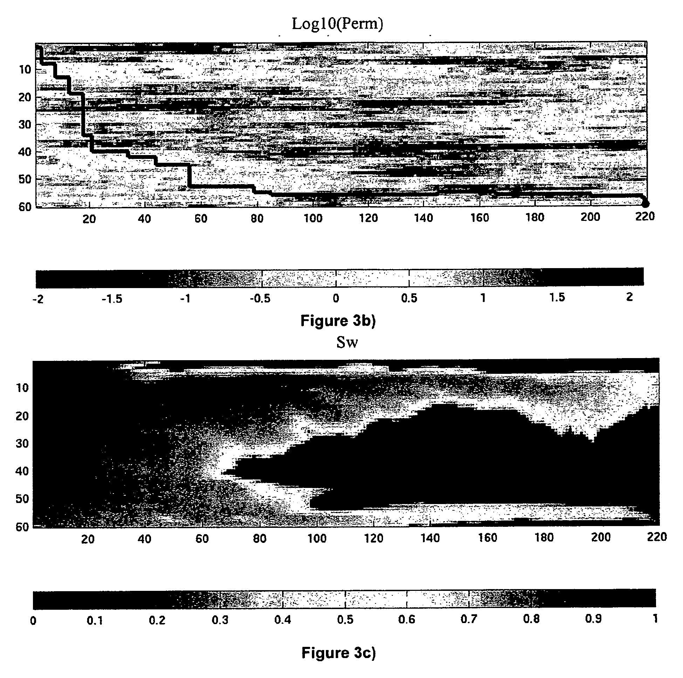

Une conséquence immédiate de cette définition est l'orientation des liens entre les mailles du réservoir. Lorsque les longueurs sont négatives (cas équivalent à une remontée contre courant), les liens correspondants sont coupés. L'impact sur l'identification du chemin le plus court entre deux puits est illustré par la figure 3b), qui représente un chemin d'écoulement le plus court pour une prise en compte d'une longueur telle que définie ci-dessus en fonction du logarithme de la perméabilité log10(Perm). Cette définition de la longueur, même si elle s'appuie sur une approximation du champ de pression, permet d'identifier de manière cohérente le chemin d'écoulement le plus court entre deux puits. Cette cohérence peut s'observer au moyen de la figure 3c) qui représente la saturation en eau (Sw) au temps de percée pour le champ de perméabilité des figures 3a) et 3b), en effet sur cette figure on peut remarquer que le chemin le plus court de la figure 3a) n'est pas envisageable alors que celui de la figure 3b), correspond bien à la circulation de l'eau.

Au cours de cette étape, suivant cette approche, on identifie les chemins d'écoulement les plus courts entre les couples (puits injecteurs, puits producteurs) et on calcule la distance de ces chemins les plus courts.

Selon une variante de réalisation, au lieu d'estimer le temps de percée, on peut estimer une probabilité de temps de percée. Dans ce cas, lorsqu'on compare la loi de probabilité et le temps de percée mesuré, la différence peut se quantifier à partir de la surface de la loi de probabilité entre le temps de percée mesuré et le temps de percée le plus probable tel que défini par cette loi de probabilité.

Au moyen de cette étape (et pour les différents modes de réalisation), on obtient un premier modèle de réservoir, pour lequel le temps de percée estimé est cohérent avec le temps de percée mesuré.

## 2) minimisation de la fonction objectif (FOB)

A ce stade, toutes les données dynamiques (DD) collectées n'ont pas été considérées pour construire le modèle de réservoir. On considère à présent l'ensemble des données dynamiques acquises en cours d'exploitation du gisement. Il s'agit de données de production, d'essais de puits, de sismique 4D... dont la particularité est de varier au cours du temps en.fonction des écoulements de fluide dans le réservoir

Ces données dynamiques vont ensuite être intégrées dans le modèle de réservoir par le biais d'une optimisation ou calage d'historique (CAL). On définit donc une fonction objectif (FOB) mesurant l'écart entre les données dynamiques mesurées (DD) sur le terrain et les réponses correspondantes simulées (SIM) pour le modèle considéré (MR) au moyen d'un simulateur d'écoulement. Parmi les simulateurs d'écoulement pouvant être utilisés, on peut citer le logiciel PumaFlow ® (IFP Énergies nouvelles, France). Le but du processus d'optimisation est de modifier petit à petit ce modèle (MR) pour minimiser la fonction objectif (FOB). Pour cela, on réitère les étapes de simulation (SIM) et de calcul de la fonction objectif (FOB) après avoir modifié les modèles de réservoir (MR). Selon l'invention, le calage d'historique débute avec le premier modèle de réservoir déterminé à l'étape précédente.

De préférence, la fonction objectif est déterminée par une mesure de type des moindres carrés qui quantifie l'écart entre données et réponses simulées. Avantageusement, on peut définir une fonction objectif $J$ qui mesure l'erreur entre les débits d'eau de référence (d) et les débits d'eau simulés ($g$(m)) pour le modèle m de réservoir testé :

$$J(\mathbf{m}) = \frac{1}{2} \sum_i \left( g(\mathbf{m})_i - d_i \right)^2$$

Selon l'invention, afin de pouvoir simuler correctement les écoulements dans le réservoir, on peut réaliser une étape de mise à l'échelle ("upscaling") du modèle de réservoir vers un modèle de réservoir grossier, dit modèle de simulation.

Avantageusement, pour modifier le modèle de réservoir, on peut utiliser une méthode de déformation graduelle, une méthode des points pilotes ou une méthode de perturbation des probabilités. Cette liste n'est pas exhaustive.

## 3) détermination du schéma d'exploitation (SE)

A partir du modèle de réservoir déterminé lors des étapes précédentes, les spécialistes peuvent déterminer plusieurs schémas d'exploitation (SE) correspondant à différentes configurations possibles d'exploitation du réservoir souterrain : emplacement des puits producteurs et/ou injecteurs, valeurs cibles pour les débits par puits et/ou pour le réservoir, le type d'outils utilisés, les fluides utilisés, injectés et/ou récupérés... Pour chacun de ces schémas, il convient de déterminer leurs prévisions de production après la période de calage. Ces prévisions de production probabilistes sont obtenues au moyen d'un logiciel de simulation d'écoulement (de préférence le même que celui utilisé auparavant) ainsi qu'au moyen du modèle numérique de réservoir calé.

On définit un ou plusieurs schémas d'exploitation (SE) possibles adapté au modèle de réservoir (appelé également modèle géologique). Pour chacun de ces schémas, on détermine les réponses par simulation.

A partir des prévisions de productions probabilistes définies pour chaque schéma d'exploitation, les spécialistes peuvent par comparaison choisir le schéma d'exploitation qui leur semble le plus pertinent. Par exemple :

- en comparant le maximum du volume d'huile récupéré, on peut déterminer le schéma de production susceptible de fournir le maximum de récupération ou d'être le plus rentable.

- en comparant l'écart type du volume d'huile récupéré, on peut déterminer le schéma de production le moins risqué.

4) exploitation du réservoir (EX)

On exploite (EX) alors le réservoir selon le schéma d'exploitation défini (SE) par exemple en forant de nouveaux puits (producteur ou injecteur), en modifiant les outils utilisés, en modifiant les débits et/ou la nature de fluides injectés...

L'invention concerne par ailleurs un produit programme d'ordinateur téléchargeable depuis un réseau de communication et/ou enregistré sur un support lisible par ordinateur et/ou exécutable par un processeur. Ce programme comprend des instructions de code de programme pour la mise en oeuvre du procédé tel que décrit ci-dessus, lorsque ledit programme est exécuté sur un ordinateur.

Exemple d'application

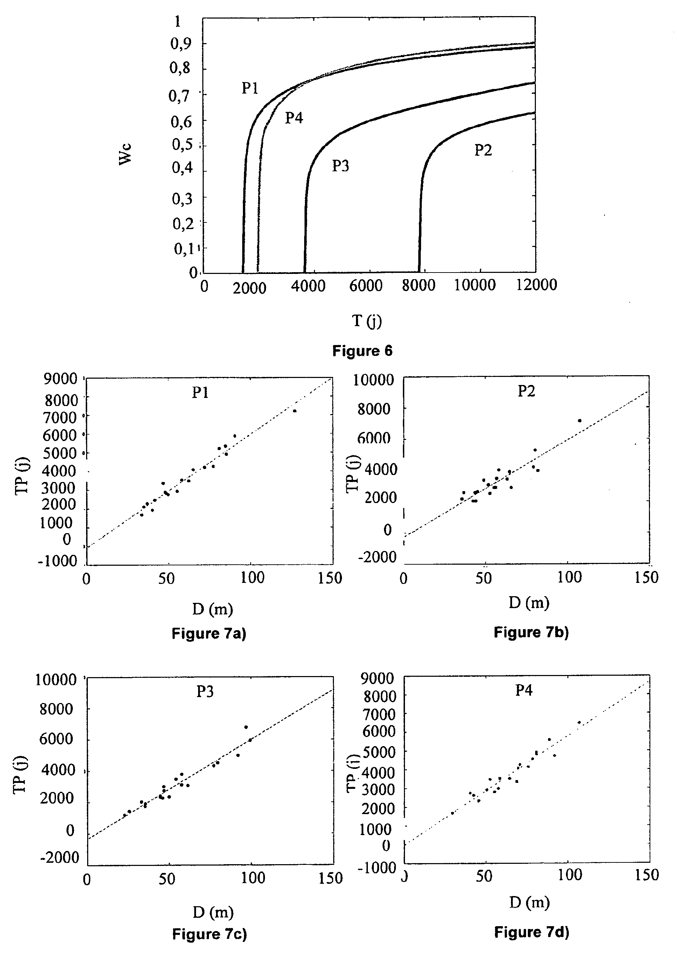

Afin de montrer l'intérêt de ce procédé pour l'exploitation des gisements d'hydrocarbures, on peut l'appliquer sur un cas simplifié de champ pétrolier. On considère le champ de perméabilité représenté sur la figure 5, comme le champ de référence. Le schéma d'exploitation s'appuie sur un puits central INJ où l'on injecte de l'eau et quatre puits producteurs (P1 à P4) dans les coins. Le réservoir est initialement saturé en huile. Les courbes de perméabilités relatives correspondent à des courbes de Corey avec des exposants fixés à 2. Les débits d'eau (Wc) produits aux puits producteurs en fonction du temps T ont été calculés à partir d'un simulateur d'écoulement (figure 6). On considère ces débits comme des données de référence. Sur ce graphique, le temps de percée correspond au temps à partir duquel le débit augmente fortement.

On suppose à présent que le champ de perméabilité n'est pas connu. L'information disponible comprend les caractéristiques de la structure spatiale du champ de perméabilité (moyenne, variance, variogramme) ainsi que les débits d'eau de référence.

On applique le procédé selon le mode de réalisation de la figure 2. On génère au hasard 20 modèles de réservoir primaires respectant la structure spatiale. Pour chacun d'entre eux, on identifie le chemin d'écoulement préférentiel (en tenant compte d'un champ de pression approché), sa longueur, et on fait une simulation d'écoulement pour obtenir les temps de percée aux puits producteurs. On met alors en évidence une relation linéaire entre longueur du chemin d'écoulement et temps de percée pour chacun des puits (figure 7a) à 7d)) avec un coefficient de corrélation supérieur à 0,9.

On rentre ensuite dans un schéma de calage plus classique pour construire un modèle de réservoir respectant non seulement le variogramme du champ de perméabilité, mais aussi les débits d'eau de référence. Dans cette optique, on définit une fonction objectif J qui mesure l'erreur entre les débits d'eau de référence (d) et les débits d'eau simulés

(g(m)) pour le modèle m de réservoir testé : $J(\mathbf{m}) = \dfrac{1}{2}\sum_i \left(g(\mathbf{m})_i - d_i\right)^2$ .

L'objectif à atteindre est la minimisation de cette fonction en modifiant itérativement le modèle de réservoir. A chaque itération, la fonction objectif est évaluée à partir d'une simulation d'écoulement. Pour pouvoir démarrer le processus de calage, il faut un point de départ, c'est à dire un modèle initial de réservoir.

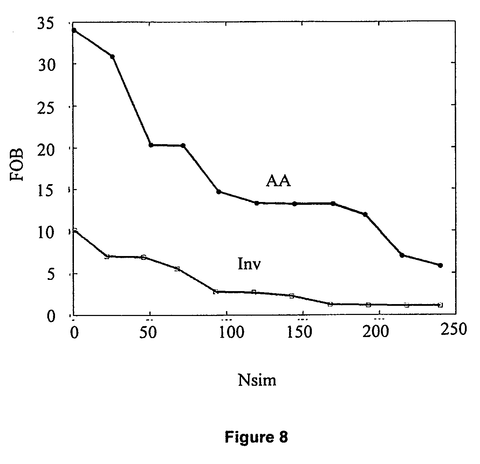

Deux tests sont réalisés. Pour le premier, le point de départ est tiré au hasard suivant la loi de probabilité a priori, tel que réalisé selon les méthodes de l'art antérieur. Pour le second, on applique le procédé selon l'invention avec l'étape de pré-sélection, de sorte qu'on pré-sélectionne un premier modèle de réservoir pour lequel les temps de percée déduits des longueurs des chemins d'écoulement les plus courts entre puits sont proches des temps de percée de référence. L'évolution de la fonction objectif (FOB) en fonction du nombre de simulations (Nsim) au cours du calage est montrée sur la figure 8 pour les deux cas : courbe AA pour le procédé sans pré-sélection et courbe INV pour le procédé selon l'invention. Pour le premier test (AA), la fonction objectif démarre à 35 et atteint environ 6 après 240 simulations d'écoulement. On note également qu'il faut environ 200 simulations pour la réduire à 10. Pour le deuxième test (INV), l'étape de pré-sélection qui a demandé en tout et pour tout 20 simulations d'écoulement, la fonction objectif démarre à 10. Puis, elle décroît pour finalement tendre vers 1 en 240 simulations. Ce test souligne bien l'intérêt de la méthode proposée pour pré-sélectionner des modèles initiaux. Au final, la pré-sélection permet d'améliorer la phase de calage des données de production.

**Revendications**

**1.** Procédé d'exploitation d'un réservoir géologique selon un schéma d'exploitation défini à partir d'un modèle de réservoir, ledit modèle de réservoir comportant un maillage associé à au moins un paramètre dudit réservoir, ledit réservoir étant traversé par au moins un puits producteur et au moins un puits injecteur pour l'injection d'au moins un fluide dans ledit réservoir, procédé pour lequel on acquiert des données dynamiques en cours d'exploitation, **caractérisé en ce qu'**on réalise les étapes suivantes :

a) on génère un premier modèle de réservoir pour lequel le temps de percée estimé au moyen dudit premier modèle de réservoir est représentatif du temps de percée mesuré pour ledit réservoir, ledit temps de percée étant le temps au bout duquel ledit fluide injecté est détecté au niveau dudit puits producteur ;

b) on construit ledit modèle de réservoir en modifiant ledit premier modèle de réservoir au moyen des étapes suivantes :

i) on détermine une fonction objectif mesurant un écart entre les données dynamiques acquises et des données dynamiques simulées au moyen dudit modèle de réservoir et d'un simulateur d'écoulement ;

ii) on réitère l'étape i) pour minimiser ladite fonction objectif après avoir modifié ledit modèle de réservoir ;

c) on détermine un schéma d'exploitation optimal dudit réservoir en simulant l'exploitation du réservoir au moyen dudit modèle de réservoir et dudit simulateur d'écoulement ; et

d) on exploite ledit réservoir en mettant en oeuvre ledit schéma d'exploitation optimal.

2. Procédé selon la revendication 1, ledit temps de percée est estimé par un algorithme de calcul de chemin le plus court.

3. Procédé selon l'une des revendications précédentes, dans lequel on génère ledit premier modèle de réservoir, en mettant en oeuvre les étapes suivantes :

(1) on détermine une relation mathématique entre ledit temps de percée et une distance d'écoulement selon le plus court chemin entre ledit puits injecteur et ledit puits producteur ;

(2) on génère aléatoirement au moins un modèle de réservoir initial ;

(3) on détermine pour ledit modèle de réservoir initial ladite distance d'écoulement selon le plus court chemin entre ledit puits injecteur et ledit puits producteur au moyen d'un algorithme de calcul de chemin le plus court, ledit algorithme étant contraint par ledit paramètre dudit modèle de réservoir initial ;

(4) on estime le temps de percée pour ledit modèle de réservoir initial au moyen de ladite distance d'écoulement et de ladite relation mathématique ;

(5) on compare ledit temps de percée estimé audit temps de percée mesuré ; et

(6) on détermine si ledit modèle de réservoir initial est représentatif au moyen de ladite comparaison, dans ce cas le modèle de réservoir initial est sélectionné en tant que premier modèle de réservoir et dans le cas contraire on réitère les étapes (2) à (5).

4. Procédé selon la revendication 3, dans lequel on détermine ladite relation mathématique entre ledit temps de percée et ladite distance d'écoulement, en effectuant les étapes suivantes :

(a) on génère aléatoirement au moins un modèle de réservoir primaire ;

(b) on détermine pour chaque modèle de réservoir primaire au moins une distance d'écoulement selon le chemin le plus court au moyen dudit algorithme de calcul de chemin le plus court ;

(c) on détermine pour chaque modèle de réservoir primaire ledit temps de percée par une simulation au moyen dudit modèle de réservoir primaire et dudit simulateur d'écoulement ; et

(d) on détermine ladite relation mathématique entre ledit temps de percée et ladite distance d'écoulement au moyen de chaque distance d'écoulement et de chaque temps de percée déterminés.

5. Procédé selon la revendication 4, dans lequel ladite relation mathématique est une fonction linéaire.

6. Procédé selon l'une des revendications 3 à 5, dans lequel ledit algorithme de calcul de chemin le plus court est l'algorithme de Dijkstra.

7. Procédé selon l'une des revendications 3 à 6, dans lequel la longueur d'un lien entre deux mailles adjacentes i et j utilisée par ledit algorithme de chemin le plus court est définie par une formule du type :

$$Longueur_{i \to j} = \frac{\sqrt{Vp_i \times Vp_j}}{T_{i \leftrightarrow j}(P_i - P_j)} \text{ avec } T_{i \leftrightarrow j} = \frac{A_{ij} K_{ij}}{D_{ij}}$$

avec : $T_{i\leftrightarrow j}$ : la transmissivité entre les mailles i et j,

$A_{ij}$ : la surface d'intersection entre les mailles i et j,

$D_{ij}$ : la distance entre les mailles i et j,

$K_{ij}$ la perméabilité moyenne le long de la connexion entre les mailles i et j,

$Vp_i$ : le volume poreux de la maille i,

$Vp_j$ : le volume poreux de la maille j,

$P_i$ : la pression de fluide dans la maille i, et

$P_j$ : la pression de fluide dans la maille j.

8. Procédé selon l'une des revendications précédentes, dans lequel préalablement à la détermination de ladite fonction objectif, on réalise une mise à l'échelle dudit modèle de réservoir pour ladite simulation.

9. Procédé selon l'une des revendications précédentes, dans lequel ladite fonction objectif mesure l'erreur entre le débit dudit fluide mesuré audit puits producteur et le débit dudit fluide simulé audit puits producteur.

10. Procédé selon l'une des revendications précédentes, dans lequel on modifie ledit modèle de réservoir au moyen d'une méthode des déformations graduelles, d'une méthode des points pilotes ou d'une méthode de perturbation des probabilités.

11. Produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé selon l'une des revendications précédentes, lorsque ledit programme est exécuté sur un ordinateur.

**Patentansprüche**

1. Verfahren zur Ausbeutung eines geologischen Speichers nach einem Ausbeutungsschema, das ausgehend von einem Speichermodell definiert ist, wobei das Speichermodell ein Gitter aufweist, das mit mindestens einem Speicherparameter assoziiert ist, wobei durch den Speicher mindestens eine Förderbohrung und mindestens eine Injektionsbohrung zur Injektion mindestens eines Fluids in den Speicher verläuft, wobei das Verfahren für das während der Ausbeutung dynamische Daten erfasst werden, **dadurch gekennzeichnet ist, dass** die folgenden Schritte ausgeführt werden:

a) Erzeugen eines ersten Speichermodells, für das die Durchbruchzeit, die mithilfe des ersten Speichermodells geschätzt wird, für die Durchbruchzeit repräsentativ ist, die für den Speicher gemessen wird, wobei es sich bei der Durchbruchzeit um die Zeit handelt, an deren Ende das injizierte Fluid in der Förderbohrung nachgewiesen wird;

b) Konstruieren des Speichermodells, indem das erste Speichermodell mithilfe der folgenden Schritte modifiziert wird:

i) Bestimmen einer Zielfunktion, die eine Abweichung zwischen den erfassten dynamischen Daten und den dynamischen Daten misst, die mithilfe des Speichermodells und einem Fließsimulator simuliert wurden;

ii) Wiederholen von Schritt i), um die Zielfunktion zu minimieren, nachdem das Speichermodell modifiziert wurde;

c) Bestimmen eines optimalen Ausbeutungsschemas des Speichers, indem die Ausbeutung des Speichers mithilfe des Speichermodells und des Fließsimulators simuliert wird; und

d) Ausbeuten des Speichers, indem das optimale Ausbeutungsschema umgesetzt wird.

2. Verfahren nach Anspruch 1, wobei die Durchbruchzeit mit einem Algorithmus zur Berechnung des kürzesten Wegs geschätzt wird.

3. Verfahren nach einem der vorhergehenden Ansprüche, wobei das erste Speichermodell erzeugt wird, indem die folgenden Schritte umgesetzt werden:

(1) Bestimmen einer mathematischen Relation zwischen der Durchbruchzeit und einem Fließabstand gemäß dem kürzesten Weg zwischen der Injektionsbohrung und der Förderbohrung;

(2) zufälliges Erzeugen mindestens eines Ausgangspeichermodells;

(3) Bestimmen, für das Ausgangsspeichermodell, des Fließabstands gemäß dem kürzesten Weg zwischen der Injektionsbohrung und der Förderbohrung mithilfe eines Algorithmus zur Berechnung des kürzesten Wegs, wobei der Algorithmus durch den Parameter des Ausgangsspeichermodells eingeschränkt ist;

(4) Schätzen der Durchbruchzeit für das Ausgangsspeichermodell mithilfe des Fließabstands und der mathematischen Relation;

(5) Vergleichen der geschätzten Durchbruchzeit mit der gemessenen Durchbruchzeit; und

(6) Bestimmen, mithilfe dieses Vergleichs, ob das Ausgangsspeichermodell repräsentativ ist, wobei in diesem Fall das Ausgangsspeichermodell als erstes Speichermodell ausgewählt wird und im gegenteiligen Fall die Schritte (2) bis (5) wiederholt werden.

4. Verfahren nach Anspruch 3, wobei die mathematische Relation zwischen der Durchbruchzeit und dem Fließabstand bestimmt wird, indem die folgenden Schritte durchgeführt werden:

(a) zufälliges Erzeugen mindestens eines primären Speichermodells;

(b) Bestimmen, für jedes primäre Speichermodell, mindestens eines Fließabstands gemäß dem kürzesten Weg mithilfe des Algorithmus zur Berechnung des kürzesten Wegs;

(c) Bestimmen für jedes primäre Speichermodell die Durchbruchzeit durch eine Simulation mithilfe des primären Speichermodells und des Fließsimulators; und

(d) Bestimmen der mathematischen Relation zwischen der Durchbruchzeit und dem Fließabstand mithilfe jedes bestimmten Fließabstands und jeder bestimmten Durchbruchzeit.

5. Verfahren nach Anspruch 4, wobei es sich bei der mathematischen Relation um eine lineare Funktion handelt.

6. Verfahren nach einem der Ansprüche 3 bis 5, wobei es sich bei dem Algorithmus zur Berechnung des kürzesten Wegs um den Dijkstra-Algorithmus handelt.

7. Verfahren nach einem der Ansprüche 3 bis 6, wobei die Länge einer Verbindung zwischen zwei benachbarten Zellen i und j, die von dem Algorithmus des kürzesten Wegs verwendet wird, durch eine Formel folgendes Typs definiert ist:

$$Länge_{i \to j} = \frac{\sqrt{Vp_i \times Vp_j}}{T_{i \leftrightarrow j}(P_i - P_j)} \text{ mit } T_{i \leftrightarrow j} = \frac{A_{ij}K_{ij}}{D_{ij}}$$

worin:

$T_{i \leftrightarrow j}$: für die Durchlässigkeit zwischen den Zellen i und j steht,
$A_{ij}$: für die Schnittfläche zwischen den Zellen i und j steht,
$D_{ij}$: für den Abstand zwischen den Zellen i und j steht,
$K_{ij}$: für die mittlere Permeabilität entlang der Verbindung zwischen den Zellen i und j steht,
$Vp_i$: für das Porenvolumen der Zelle i steht,
$Vp_j$: für das Porenvolumen der Zelle j steht,
$P_i$: für den Fluiddruck in der Zelle i steht und
$P_j$: für den Fluiddruck in der Zelle j steht.

8. Verfahren nach einem der vorhergehenden Ansprüche, wobei vor der Bestimmung der Zielfunktion, eine Skalierung des Speichermodells für die Simulation ausgeführt wird.

9. Verfahren nach einem der vorhergehenden Ansprüche, wobei die Zielfunktion den Fehler zwischen dem Fluiddurchfluss, der an der Förderbohrung gemessen wird, und dem Fluiddurchfluss, der an der Förderbohrung simuliert wird, misst.

10. Verfahren nach einem der vorhergehenden Ansprüche, wobei das Speichermodell mithilfe einer Methode der graduellen Deformationen, einer Methode mit Pilot-Punkten oder einer Methode der Störung der Wahrscheinlichkeit (probability pertubation) modifiziert wird.

11. Computerprogrammprodukt, das von einem Kommunikationsnetzwerk heruntergeladen und/oder auf einem computerlesbaren Datenträger gespeichert und/oder von einem Prozessor ausgeführt werden kann, aufweisend Programmcode-Anweisungen zur Durchführung des Verfahrens nach einem der vorhergehenden Ansprüche, wenn das Programm auf einem Computer ausgeführt wird.

**Claims**

1. A method for developing a geological reservoir according to a development scheme defined from a reservoir model, said reservoir model comprising a grid associated with at least one parameter of said reservoir, said reservoir being traversed by at least one production well and at least one injection well for injection of at least one fluid into said reservoir, a method wherein dynamic data are acquired during development, **characterized in that** the following stages are carried out:

   a) generating a first reservoir model where the breakthrough time estimated by means of said first reservoir model is representative of the breakthrough time measured for said reservoir, said breakthrough time being the time required for said injected fluid to be detected at said production well,
   b) constructing said reservoir model by modifying said first reservoir model by means of the following stages:

      i) determining an objective function measuring a difference between acquired dynamic data and dynamic data simulated using said reservoir model and a flow simulator,
      ii) repeating stage i) so as to minimize said objective function after modifying said reservoir model,

   c) determining an optimum development scheme for said reservoir by simulating reservoir development by means of said reservoir model and said flow simulator, and
   d) developing said reservoir by implementing said optimum development scheme.

2. A method as claimed in claim 1, wherein the breakthrough time is estimated by means of a shortest path algorithm.

3. A method as claimed in any one of the previous claims, wherein said first reservoir model is generated by carrying out the following stages:

   (1) determining a mathematical relation between said breakthrough time and a shortest-path flow distance between said injection well and said production well,
   (2) randomly generating at least one initial reservoir model,
   (3) determining for said initial reservoir model said shortest-path flow distance between said injection well and said production well by means of a shortest path algorithm, said algorithm being constrained by said parameter of said initial reservoir model,
   (4) estimating the breakthrough time for said initial reservoir model by means of said flow distance and of said mathematical relation,
   (5) comparing said estimated breakthrough time and said measured breakthrough time, and
   (6) determining whether said initial reservoir model is representative by means of said comparison, in which case the initial reservoir model is selected as the first reservoir model and, in the opposite case, stages (2) to (5) are repeated.

4. A method as claimed in claim 3, wherein said mathematical relation between said breakthrough time and said flow distance is determined by carrying out the following stages:

   (a) randomly generating at least one primary reservoir model,
   (b) determining for each primary reservoir model at least one shortest-path flow distance by means of said shortest path algorithm,
   (c) determining for each primary reservoir model said breakthrough time by a simulation using said primary reservoir model and said flow simulator, and
   (d) determining said mathematical relation between said breakthrough time and said flow distance by means of each flow distance and each breakthrough time determined.

5. A method as claimed in claim 4, wherein said mathematical relation is a linear function.

6. A method as claimed in any one of claims 3 to 5, wherein said shortest path algorithm is Dijkstra's algorithm.

7. A method as claimed in any one of claims 3 to 6, wherein the length of a link between two adjacent cells i and j used by said shortest path algorithm is defined by a formula of the type:

$$Length_{i \to j} = \frac{\sqrt{Vp_i \times Vp_j}}{T_{i \leftrightarrow j}(P_i - P_j)} \ with \ T_{i \leftrightarrow j} = \frac{A_{ij} K_{ij}}{D_{ij}}$$

with:

$T_{i \leftrightarrow j}$ : transmissivity between cells i and j,
$A_{ij}$ : surface of intersection between cells i and j,
$D_{ij}$ : distance between cells i and j,
$K_{ij}$ : mean permeability along the connection between cells i and j,
$Vp_i$ : pore volume of cell i,
$Vp_j$ : pore volume of cell j,
$P_i$ : fluid pressure in cell i, and
$P_j$ : fluid pressure in cell j.

8. A method as claimed in any one of the previous claims wherein, prior to determining said objective function, scaling of said reservoir model is performed for said simulation.

9. A method as claimed in any one of the previous claims, wherein said objective function measures the error between the flow rate of said fluid measured at said production well and the flow rate of said fluid simulated at said production well.

10. A method as claimed in any one of the previous claims, wherein said reservoir model is modified by means of a gradual deformation method, a pilot point method or a probability perturbation method.

11. A computer program product downloadable from a communication network and/or recorded on a computer-readable medium and/or processor executable, comprising program code instructions for implementing the method as claimed in any one of the previous claims, when said program is executed on a computer.

**Figure 1**

**Figure 2**

Log10(Perm)

**Figure 3a)**

Log10(Perm)

**Figure 3b)**

Sw

**Figure 3c)**

**Figure 4**

**Figure 5**

Figure 6

Figure 7a)

Figure 7b)

Figure 7c)

Figure 7d)

Figure 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2253797 A

**Littérature non-brevet citée dans la description**

- **GOOVAERTS,P.** Geostatistics for natural resources evaluation. Oxford Press, 1997
- **LE RAVALEC, M. ; NOETINGER B. ; HU L.-Y.** The FFT moving average (FFT-MA) generator: an efficient numerical method for generating and conditioning Gaussian simulations. *Mathematical Geology,* 2000, vol. 32 (6), 701-723
- **RAMARAO, B.S ; LAVENUE, A.M. ; MARSILLY, G. DE ; MARIETTA, M.G.** Pilot point methodology for automated calibration of an ensemble of conditionally simulated transmissivity fields. 1. *Theory and computational experiments. WRR,* 1995, vol. 31 (3), 475-493
- **GOMEZ-HERNANDEZ, J. ; SAHUQUILLO, A. ; CAPILLA, J.E.** Stochastic simulation of transmissivity fields conditional to both transmissivity and piezometric data, 1. Theory. *J. of Hydrology,* 1997, vol. 203, 162-174
- **HU, L-Y.** Gradual Deformation and iterative calibration of Gaussian-related stochastic models. *Math. Geol.,* 2000, vol. 32 (1), 87-108
- **CAERS, J.** Geostatistical history matching under training-image based geological constraints. *SPE J.,* 2003, vol. 8 (3), 218-226